# EUROPEAN PATENT SPECIFICATION

(11) **EP 3 891 237 B1**
(45) Date of publication and mention of the grant of the patent: **22.07.2026**
(21) Application number: 19894172.6
(22) Date of filing: 13.11.2019
(51) Int. Cl.: C09G 1/02, H10P 52/40, H10P 95/00

(54) **COMPOSITIONS AND METHOD FOR COBALT CMP**
ZUSAMMENSETZUNGEN UND VERFAHREN FÜR KOBALT-CMP
COMPOSITIONS ET PROCÉDÉ POUR LE POLISSAGE CHIMICO-MÉCANIQUE DU COBALT

(30) Priority: 04.12.2018 US 201816208703
(43) Date of publication of application: 13.10.2021
(73) Proprietor: CMC Materials LLC, Wilmington, DE 19801 (US)
(72) Inventor: HUNG LOW, Fernando, Aurora, Illinois 60504 (US); KRAFT, Steven, Aurora, Illinois 60504 (US); IVANOV, Roman A., Aurora, Illinois 60504 (US); GRUMBINE, Steven, Aurora, Illinois 60504 (US); WOLFF, Andrew, Aurora, Illinois 60504 (US)
(74) Representative: Barker Brettell LLP
(86) International application number: PCT/US2019/061247
(87) International publication number: WO 2020/117438

(56) References cited:
- WO-A1-2004/069947
- US-A1- 2007 167 016
- US-A1- 2010 087 065
- US-A1- 2011 318 929
- US-A1- 2014 363 973
- US-A1- 2014 363 973
- US-A1- 2018 043 497

## Description

### BACKGROUND OF THE INVENTION

Tungsten plug and interconnect and copper interconnect and dual damascene processes are back end of the line (BEOL) processes that have long been employed to form the network of metal wires that connect the transistors in a conventional semiconductor device. In these processes tungsten or copper metal is deposited in openings formed in a dielectric material (e.g., TEOS). Chemical mechanical polishing (CMP) is used to remove the excess tungsten or copper from the dielectric and thereby form tungsten or copper plugs and/or interconnects therein. An interlayer dielectric (ILD) material (such as TEOS) is deposited between metal interconnect levels to provide electrical insulation between the levels.

As transistor sizes continue to shrink, the use of conventional interconnect technology has become increasingly challenging. Recently, cobalt has emerged as a leading candidate to replace the tantalum/tantalum nitride barrier stack in copper interconnects. Cobalt is also being actively investigated as a replacement for tungsten metal in multiple BEOL applications. With the potential introduction of cobalt as a barrier layer and/or tungsten plug and/or interconnect replacement, there is an emerging need for CMP slurries that are able to planarize cobalt containing substrates.

In general, commercially available CMP slurries fabricated for removing tungsten, copper, or other metal layers are ill-equipped for polishing cobalt, particularly in advanced node devices. For example, Co tends to be chemically active and can be susceptible to various corrosion issues during a CMP process. There is a need for CMP slurries that can remove cobalt films and/or effectively planarize cobalt containing substrates while not causing corresponding cobalt corrosion.

CMP compositions comprising a compound having a 1,2,3-triazolo[4,5-b]pyridine skeleton as a metal corrosion inhibitor are described in US Patent Application 2011/0318929 A1.

### BRIEF SUMMARY OF THE INVENTION

A chemical mechanical polishing composition for polishing a substrate having a cobalt layer is disclosed. The polishing composition comprises, consists essentially of, or consists of a water based liquid carrier, cationic silica abrasive particles dispersed in the liquid carrier, wherein the cationic silica abrasive particles have a zeta potential of at least 10 mV in the polishing composition, a triazole compound, wherein the triazole compound is not benzotriazole or a benzotriazole compound, and wherein the polishing composition has a pH of from 6.5 to 9. In one embodiment, the silica abrasive particles comprise colloidal silica particles and the triazole compound comprises a triazole pyridine compound such as 1H-1,2,3-Triazolo[4,5-b] pyridine. A method for chemical mechanical polishing a substrate including a cobalt layer is further disclosed. The method may include contacting the substrate with the above described polishing composition, moving the polishing composition relative to the substrate, and abrading the substrate to remove a portion of the cobalt from the substrate and thereby polish the substrate. The method may further comprise removing a portion of a dielectric layer from the substrate.

### DETAILED DESCRIPTION OF THE INVENTION

A first aspect of the present invention relates to a chemical mechanical polishing composition for polishing a cobalt containing substrate, as defined in claim 1.

A second aspect of the present invention relates to a method of chemical mechanical polishing a substrate including a cobalt layer, as defined in claim 10.

A third aspect of the present invention relates to a chemical mechanical polishing composition for polishing a cobalt containing substrate, as defined in claim 14.

Particular embodiments are defined in the dependent claims.

A chemical mechanical polishing composition for polishing a substrate having a cobalt layer is disclosed. The polishing composition comprises, consists essentially of, or consists of a water based liquid carrier, cationic silica abrasive particles dispersed in the liquid carrier, and a triazole compound. The polishing composition has a pH of 6.5 to 9 and the cationic silica abrasive particles have a zeta potential of at least 10 mV in the polishing composition. The triazole compound is not benzotriazole or a benzotriazole compound. In one embodiment, the silica abrasive particles include colloidal silica particles treated with an aminosilane compound and the triazole compound comprises a triazole pyridine compound such as 1H-1,2,3-Triazolo[4,5-b] pyridine.

It will be appreciated that the disclosed CMP compositions may be advantageously utilized for bulk cobalt removal and/or cobalt buff CMP operations. Bulk removal operations may require higher cobalt removal rates while buff operations may require lower defect levels and/or more stringent corrosion control. The disclosed CMP compositions may also be advantageously utilized for a single-step cobalt CMP operation. While the disclosed embodiments may be particularly well suited for cobalt buff operations, they are not intended to be limited to any particular cobalt CMP operation.

The polishing composition contains an abrasive including metal oxide particles suspended in a liquid carrier. The abrasive may include substantially suitable metal oxide particles, for example, including colloidal silica particles and/or fumed silica particles. As used herein the term colloidal silica particles refers to silica particles that are prepared via a wet process rather than a pyrogenic or flame hydrolysis process which commonly produces structurally different particles. Such colloidal silica particles may be aggregated or non-aggregated. Non-aggregated particles are individually discrete particles that may be spherical or nearly spherical in shape, but can have other shapes as well (such as generally elliptical, square, or rectangular cross-sections). Aggregated particles are particles in which multiple discrete particles are clustered or bonded together to form aggregates having generally irregular shapes.

Colloidal silica may be precipitated or condensation-polymerized silica, which may be prepared using any method known to those of ordinary skill in the art, such as by the sol gel method or by silicate ion-exchange. Condensation-polymerized silica particles are often prepared by condensing Si(OH)₄ to form substantially spherical particles. The precursor Si(OH)₄ may be obtained, for example, by hydrolysis of high purity alkoxysilanes, or by acidification of aqueous silicate solutions. Such abrasive particles may be prepared, for example, in accordance with U.S. Pat. No. 5,230,833 or may be obtained from any of a number of commercial suppliers, for example, including EKA Chemicals, Fuso Chemical Company, Nalco, DuPont, Bayer, Applied Research, Nissan Chemical, and Clariant.

Pyrogenic silica is produced via a flame hydrolysis process in which a suitable feedstock vapor (such as silicon tetra-chloride) is combusted in a flame of hydrogen and oxygen. Molten particles of roughly spherical shapes are formed in the combustion process, the diameters of which may be varied via process parameters. These molten spheres, commonly referred to as primary particles, fuse with one another by undergoing collisions at their contact points to form branched, three dimensional chain-like aggregates. Fumed silica abrasives are commercially available from a number of suppliers including, for example, Cabot Corporation, Evonic, and Wacker Chemie.

The abrasive particles may have substantially any suitable particle size. The particle size of a particle suspended in a liquid carrier may be defined in the industry using various means. For example, the particle size may be defined as the diameter of the smallest sphere that encompasses the particle and may be measured using a number of commercially available instruments, for example, including the CPS Disc Centrifuge, Model DC24000HR (available from CPS Instruments, Prairieville, Louisiana) or the Zetasizer^{®} available from Malvern Instruments^{®}. The abrasive particles may have an average particle size of about 5 nm or more (e.g., about 10 nm or more, about 20 nm or more, or about 30 nm or more). The abrasive particles may have an average particle size of about 200 nm or less (e.g., about 160 nm or less, about 140 nm or less, about 120 nm or less, or about 100 nm or less). It will thus be understood that the abrasive particles may have an average particle size in a range bounded by any two of the aforementioned endpoints. For example, the abrasive particles may have an average particle size in a range from about 5 nm to about 200 nm (e.g., from about 10 nm to about 160 nm, from about 20 nm to about 140 nm, from about 20 nm to about 120 nm, or from about 20 nm to about 100 nm).

The polishing composition may include substantially any suitable amount of the abrasive particles. If the polishing composition comprises too little abrasive, the composition may not exhibit a sufficient removal rate. In contrast, if the polishing composition comprises too much abrasive, then the polishing composition may exhibit undesirable polishing performance and/or may not be cost effective and/or may lack stability. The polishing composition may include about 0.01 wt. % or more abrasive particles (e.g., about 0.05 wt. % or more). The polishing composition may include about 0.1 wt. % or more (e.g., about 0.2 wt. % or more, about 0.3 wt. % or more, or 0.5 wt. % or more) abrasive particles. The concentration of abrasive particles in the polishing composition is generally less than about 20 wt. %, and more typically about 10 wt. % or less (e.g., about 5 wt. % or less, about 3 wt. % or less, about 2 wt. % or less, or about 1.5 wt. % or less, or about 1 wt. % or less). It will be understood that the abrasive particles may be present in the polishing composition at a concentration bounded by any two of the aforementioned endpoints. For example, the concentration of abrasive particles in the polishing composition may be in a range from about 0.01 wt. % to about 20 wt. %, and more preferably from about 0.05 wt. % to about 10 wt. % (e.g., from about 0.1 wt. % to about 5 wt. %, from about 0.1 wt. % to about 3 wt. %, from about 0.1 wt. % to about 2 wt. %, from about 0.2 wt. % to about 2 wt. %, from about 0.2 wt. % to about 1.5 wt. %, or from about 0.2 wt. % to about 1 wt. %,).

In embodiments in which the abrasive particles comprise silica (such as colloidal or pyrogenic silica) the silica particles may have a positive charge in the polishing composition. The charge on dispersed particles such as silica particles is commonly referred to in the art as the zeta potential (or the electrokinetic potential). The zeta potential of a particle refers to the electrical potential difference between the electrical charge of the ions surrounding the particle and the electrical charge of the bulk solution of the polishing composition (e.g., the liquid carrier and any other components dissolved therein). Accordingly, silica abrasive particles with a positive charge (i.e., cationic silica abrasive particles) will have a positive zeta potential at their operating pH. The zeta potential is typically dependent on the pH of the aqueous medium. For a given composition, the isoelectric point of the particles is defined as the pH at which the zeta potential is zero. As the pH is increased or decreased away from the isoelectric point, the surface charge (and hence the zeta potential) is correspondingly decreased or increased (to negative or positive zeta potential values). The zeta potential of dispersed abrasive particles, such as in the disclosed polishing compositions, may be obtained using commercially available instrumentation such as the Zetasizer available from Malvern Instruments, the ZetaPlus Zeta Potential Analyzer available from Brookhaven Instruments, and/or an electro-acoustic spectrometer available from Dispersion Technologies, Inc.

In certain embodiments, the cationic silica abrasive particles have an isoelectric point greater than pH 7. For example, the abrasive particles may have an isoelectric point greater than pH 8 (e.g., greater than pH 8.5 or greater than pH 9). As described in more detail below the abrasive particles may optionally comprise colloidal silica particles treated with a nitrogen containing compound such as an aminosilane compound.

The cationic silica abrasive particles have a zeta potential of 10 mV or more (e.g., about 15 mV or more, about 20 mV or more, about 25 mV or more, or about 30 mV or more) in the polishing composition (e.g., at a pH greater than about 6 or at a pH in a range from about 6 to about 8). The cationic silica abrasive particles may have a zeta potential of about 50 mV or less (e.g., about 45 mV or less or about 40 mV or less) in the polishing composition (e.g., at a pH greater than about 6 or at a pH in a range from about 6 to about 8). It will be understood that the cationic silica abrasive particles may have a zeta potential in a range bounded by any two of the aforementioned endpoints. For example, the cationic silica abrasive particles may have a zeta potential in a range from 10 mV to about 50 mV (e.g., 10 mV to about 45 mV, or about 20 mV to about 40 mV) in the polishing composition (e.g., at a pH greater than about 6 or at a pH in a range from about 6 to about 8).

In certain embodiments, the cationic silica abrasive particles may comprise colloidal silica particles treated with an aminosilane compound such that the treated abrasive particles have a zeta potential of about 10 mV or more (e.g., about 15 mV or more, about 20 mV or more, about 25 mV or more, or about 30 mV or more) in the polishing composition (e.g., at a pH greater than about 6, greater than about 7, greater than about 7.5, or greater than about 8). In certain of these embodiments, the abrasive particles comprise colloidal silica particles treated with a quaternary aminosilane compound. Such cationic colloidal silica particles may be obtained, for example, via treating the particles with at least one aminosilane compound as disclosed in commonly assigned U.S. Patents 7,994,057 and 9,028,572 or in U.S. Patent 9,382,450. Colloidal silica particles having a zeta potential of about 10 mV or more in the polishing composition may also be obtained by incorporating a chemical species, such as an aminosilane compound, in the colloidal silica particles as disclosed in in commonly assigned U.S. Patent 9,422,456.

It will be understood that that example cationic colloidal silica particles may be treated using any suitable treating method to obtain the cationic colloidal silica particles. For example, a quaternary aminosilane compound and the colloidal silica may be added simultaneously to some or all of the other components in the polishing composition. Alternatively, the colloidal silica may be treated with the quaternary aminosilane compound (e.g., via a heating a mixture of the colloidal silica and the aminosilane) prior to mixing with the other components of the polishing composition.

In certain embodiments, the cationic silica abrasive particles may have a permanent positive charge. By permanent positive charge it is meant that the positive charge on the silica particles is not readily reversible, for example, via flushing, dilution, filtration, and the like. A permanent positive charge may be the result, for example, of covalently bonding a cationic compound with the colloidal silica. A permanent positive charge is in contrast to a reversible positive charge that may be the result, for example, of an electrostatic interaction between a cationic compound and the colloidal silica.

Notwithstanding, as used herein, a permanent positive charge of at least 10 mV means that the zeta potential of the colloidal silica particles remains above 10 mV after the following three step ultrafiltration test. A volume of the polishing composition (e.g., 200 ml) is passed through a Millipore Ultracell regenerated cellulose ultrafiltration disk (e.g., having a MW cutoff of 100,000 Daltons and a pore size of 6.3 nm). The remaining dispersion (the dispersion that is retained by the ultrafiltration disk) is collected and replenished to the original volume with pH adjusted deionized water. The deionized water is pH adjusted to the original pH of the polishing composition using a suitable inorganic acid such as nitric acid. This procedure is repeated for a total of three ultrafiltration cycles (each of which includes an ultrafiltration step and a replenishing step). The zeta-potential of the triply ultra-filtered and replenished polishing composition is then measured and compared with the zeta potential of the original polishing composition. This three step ultrafiltration test is described in further detail in Example 10 of commonly assigned U.S. Patent 9,422,456, which is incorporated herein by reference in its entirety.

A liquid carrier is used to facilitate the application of the abrasive and any optional chemical additives to the surface of the substrate to be polished (e.g., planarized). The liquid carrier may be any suitable carrier (e.g., a solvent) including lower alcohols (e.g., methanol, ethanol, etc.), ethers (e.g., dioxane, tetrahydrofuran, etc.), water, and mixtures thereof. Preferably, the liquid carrier comprises, consists essentially of, or consists of water, more preferably deionized water.

The polishing composition is generally neutral having a pH in a range from 6.5 to 9. For example, the polishing composition may have a pH of about 7 or more, or about 7.5 or more when measured at 1 atmosphere and 25 degrees C. The polishing composition has pH of 9 or less (e.g., about 8 or less or about 7.5 or less). The polishing composition may thus have a pH in a range bounded by any two the above endpoints. For example, the pH may be in a range from 6.5 to 8, from about 7 to about 8.5, or from about 7 to about 8. The pH of the polishing composition may be achieved and/or maintained by any suitable means. The polishing composition may include substantially any suitable pH adjusting agents or buffering systems. For example, suitable pH adjusting agents may include nitric acid, sulfuric acid, phosphoric acid, and the like as well as organic acids such as acetic acid and lactic acid. Suitable buffering agents may include phosphates, ammonium salts, and the like.

The polishing composition further includes an inhibitor of cobalt etching and/or corrosion. Cobalt metal is known to be susceptible to corrosion attack in acidic and neutral environments. The cobalt inhibitor is intended to reduce the rate of dissolution (dissolving) of cobalt metal in the CMP composition. In certain embodiments, the cobalt inhibitor includes a triazole compound. Preferred triazole compounds include triazole pyridine (TAP) compounds such as 1H-1,2,3-Triazolo[4,5,b] pyridine, 1-Acetyl-1H-1,2,3-triazolo[4,5,b] pyridine, 3H-[1,2,3]Triazolo[4,5-c] pyridine, and 2-(1,2,4-Triazol-3-yl) pyridine. The most preferred copper inhibitor is 1H-1,2,3-Triazolo[4,5,b] pyridine. The structure of 1H-1,2,3-Triazolo[4,5,b] pyridine is shown below. 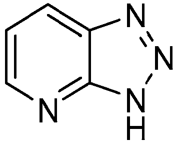 1H-1,2,3-Triazolo[4,5,b] pyridine

While the cobalt inhibitor may include a triazole compound, such as a triazole pyridine compound, it will be understood that the cobalt inhibitor does not include benzotriazole or a benzotriazole compound (such as benzotriazole, 5-Methyl-1H-benzotriazole, or 1H-Benzotriazole-1-methanol). Benzotriazole (BTA) is a well-known and highly effective copper corrosion inhibitor that is commonly used in commercial copper CMP slurries. As shown in Example 1 below, BTA and certain BTA compounds may function as cobalt inhibitors in CMP polishing compositions. However, it has been found that the use of BTA or BTA compounds can be disadvantageous in CMP polishing compositions for at least the following reason. These compounds are believed to form an organic film that strongly adheres to the cobalt substrate (this film presumably inhibits cobalt corrosion). The presence of this strongly adhered film has been found to result in an abundance of organic surface residue defects on the wafer after the post CMP cleaning operation (as removal of the film has proven difficult). The surface defects have been observed to remain even after multiple post CMP cleaning steps using alkaline cleaners.

As described above, the cobalt inhibitor preferably includes a triazole pyridine compound. Those of ordinary skill in the art will readily understand that triazole pyridine compounds include a triazole group bonded to a pyridine ring. In certain embodiments, the pyridine ring and the triazole group share first and second carbon atoms (and are thus bonded together at the first and second carbon atoms). In contrast, benzotriazole compounds include a triazole group bonded to a benzene ring. Triazole pyridine compounds do not include a benzene ring.

The above disclosure that the cobalt inhibitor does not include benzotriazole or a benzotriazole compound is not intended to mean that the polishing composition must be free of benzotriazole or a benzotriazole compound. On the contrary, in embodiments including multiple triazole compounds it will be understood that at least one of the triazole compounds is not benzotriazole or a benzotriazole compound. For example, it will be understood that in certain embodiments the polishing composition may additionally include low levels of benzotriazole or a benzotriazole compound (e.g., less than 50 ppm, or less than 20 ppm, or less than 10 ppm, or even less than 5 ppm) in addition to the above-recited triazole compound cobalt inhibitor.

The amount of the cobalt inhibitor compound in the polishing composition may be varied depending upon the particular compound used, whether or not an oxidizing agent is used, the pH of the polishing composition, and other factors. When the preferred cobalt inhibitor is a triazole pyridine compound and the pH of the composition is neutral (e.g., from about 5 to about 9), the cobalt inhibitor may be present in the polishing composition in an amount ranging from about 10 to about 2000 ppm based on the total weight of the composition. In certain embodiments, the polishing composition may include about 10 ppm or more of the triazole pyridine compound (e.g., about 20 ppm or more, about 50 ppm or more, or about 100 ppm or more). The polishing composition may also include about 2000 ppm or less of the triazole pyridine compound (e.g., about 1000 ppm or less, about 700 ppm or less, or about 500 ppm or less). It will thus be understood that the triazole pyridine cobalt etch inhibitor may be present in the polishing composition at a concentration bounded by any two of the aforementioned endpoints. For example, the polishing composition may include from about 20 to about 1000 ppm of the triazole pyridine compound (e.g., from about 50 to about 1000 ppm, from about 50 to about 500, or from about 100 to about 500 ppm).

The polishing composition is preferably free of oxidizing agents that include a per-compound. In other words, it is preferred that per-compounds are not present in the polishing composition and are not intentionally added to the polishing composition. In such embodiments, the concentration of per-compound oxidizing agents in the polishing composition is essentially zero (e.g., less than 1 ppm by weight, less than 0.3 ppm by weight, or less than 0.1 ppm by weight). A per-compound as defined herein is a compound containing at least one peroxy group (-O--O-) or a compound containing a halogen element in its highest oxidation state. Examples of compounds containing at least one peroxy group include but are not limited to hydrogen peroxide and its adducts such as urea hydrogen peroxide, percarbonates, perborates, perboric acid, organic peroxides such as benzoyl peroxide, peracetic acid, and di-t-butyl peroxide, monopersulfates (SO₅⁼), dipersulfates (S₂O₈⁼), and sodium peroxide. Examples of compounds containing a halogen element in its highest oxidation state include but are not limited to periodic acid, periodate salts, perbromic acid, perbromate salts, perchloric acid, and perchlorate salts.

Per-compounds (including hydrogen peroxide and its adducts) are known to chemically react with triazole compounds including the aforementioned cobalt inhibitor compounds. Elimination of such per-compounds may therefore improve the chemical stability of the cobalt inhibitor and advantageously improve the pot life of the polishing composition.

The polishing composition may optionally (but does not necessarily) include an oxidizing agent that does not include a per compound (a non per compound oxidizing agent). Such a non per compound oxidizing agent may be selected from nitrogen containing organic oxidizers such as a nitro compound, a nitroso compound, an N-oxide compound, an oxime compound, and combinations thereof. For example, the optional oxidizing agent may include an aryl nitro compound, an aryl nitroso compound, an aryl N-oxide compound, an aryl oxime compound, a heteroaryl nitro compound, a heteroaryl nitroso compound, a heteroaryl N-oxide compound, a heteroaryl oxime compound, and combinations thereof.

In optional embodiments including a non per oxidizing agent, the oxidizing agent may be present in substantially any suitable concentration. The oxidizing agent may be present in the polishing composition at a concentration of about 1 mM or more, for example, about 5 mM or more, about 10 mM or more, about 20 mM or more, about 30 mM or more, about 40 mM or more, or about 50 mM or more. The oxidizing agent may also be present in the polishing composition at a concentration of about 100 mM or less, for example, about 90 mM or less, about 80 mM or less, about 70 mM or less, or about 60 mM or less. It will be understood that the oxidizing agent may be present in the polishing composition at a concentration bounded by any two of the aforementioned endpoints. For example, the oxidizing agent can be present in the polishing composition at a concentration in a range from about 1 mM to about 100 mM, (e.g., about 5 to about 90 mM, about 10mM to about 80 mM, about 20 mM to about 70 mM, or about 20 mM to about 60 mM).

The polishing composition may further optionally (but does necessarily) include a cobalt polishing accelerator. The cobalt accelerator can be any suitable cobalt accelerator selected from an *N*-di(carboxylalkyl)amine, an *N*-di(hydroxyalkyl)amine, an *N,N-*di(hydroxyalkyl)-*N*-carboxylalkylamine, a dicarboxyheterocycle, a heterocyclylalkyl-α-amino acid, an *N*-aminoalkylamino acid, an unsubstituted heterocycle, an alkyl-substituted heterocycle, a carboxylic acid, a dicarboxylic acid, a tricarboxylic acid, an alkylamine, an *N*-aminoalkyl-α-amino acid, and combinations thereof. For example, the polishing composition may optionally include a cobalt accelerator selected from iminodiacetic acid ("IDA"), *N*-(2-acetamido)iminodiacetic acid ("ADA"), *N-*methylimidazole, picolinic acid, dipicolinic acid, 4-(2-hydroxyethyl)-1-piperazineethanesulfonic acid, glycine, bicine, triethylamine ("TEA"), etidronic acid, *N-*methylmorpholine, malonic acid, 2-pyridinesulfonate, citric acid and combinations thereof.

In optional embodiments including a cobalt accelerator, the cobalt accelerator may be present in the polishing composition in any suitable concentration. In certain optional embodiments, the cobalt accelerator may be present in the polishing composition at a concentration of about 5 mM or more (e.g., about 10 mM or more, about 20 mM or more, or about 40 mM or more). The cobalt accelerator may be present in the polishing composition at a concentration of about 100 mM or less (e.g., about 80 mM or less, about 60 mM or less, or about 50 mM or less). The cobalt accelerator may be present in the polishing composition at a concentration bounded by any two of the aforementioned endpoints, for example, in a range from about 5 mM to about 100 mM, from about 10 mM to about 80 mM, or from about 20 mM to about 60 mM.

The polishing composition may optionally further include a biocide. The biocide may include any suitable biocide, for example an isothiazolinone biocide such as Kordek^{®} biocides available from Dow Chemical Company. The polishing composition may include substantially any suitable amount of biocide. For example, certain embodiments may include from about 1 to about 1000 ppm of the biocide, for example, from about 10 to about 500 ppm. The disclosed embodiments are explicitly not limited to the use of any particular biocide compound or concentration.

The polishing composition may be prepared using any suitable techniques, many of which are known to those skilled in the art. The polishing composition may be prepared in a batch or continuous process. Generally, the polishing composition may be prepared by combining the components thereof in any order. The term "component" as used herein includes the individual ingredients (e.g., the abrasive particles, the cobalt inhibitor, etc.)

For example, colloidal silica and a quaternary aminosilane compound may be mixed in an aqueous liquid carrier. The mixture may optionally be heated (e.g., to a temperature of about 50 to 80 degrees C) to promote bonding of the aminosilane compound to the colloidal silica. Other components such as a cobalt inhibitor and a biocide may then be added and mixed by any method that is capable of incorporating the components into the polishing composition. The polishing composition also may also be prepared by mixing the components at the surface of the substrate (e.g., on the polishing pad) during the CMP operation.

The polishing composition of the invention may also be provided as a concentrate which is intended to be diluted with an appropriate amount of water prior to use. In such an embodiment, the polishing composition concentrate may include abrasive particles, the cobalt inhibitor, the optional biocide, and water, in amounts such that, upon dilution of the concentrate with an appropriate amount of water each component of the polishing composition will be present in the polishing composition in an amount within the appropriate range recited above for each component. For example, abrasive particles and the cobalt inhibitor may be present in the polishing composition in an amount that is about 2 times (e.g., about 3 times, about 4 times, about 5 times, or about 10 times) greater than the concentration recited above for each component so that, when the concentrate is diluted with an equal volume of water (e.g., 1 equal volume of water, 2 equal volumes of water, 3 equal volumes of water, 4 equal volumes of water, or even 9 equal volumes of water respectively), each component will be present in the polishing composition in an amount within the ranges set forth above for each component. Furthermore, as will be understood by those of ordinary skill in the art, the concentrate may contain an appropriate fraction of the water present in the final polishing composition in order to ensure that other components are at least partially or fully dissolved in the concentrate.

Although the polishing composition of the invention may be used to polish any substrate, the polishing composition is particularly useful for polishing a substrate comprising at least one cobalt containing layer. The substrate may further include a dielectric layer including a metal oxide such as a silicon oxide layer derived from tetraethyl orthosilicate (TEOS), porous metal oxide, porous or non-porous carbon doped silicon oxide, fluorine-doped silicon oxide, glass, organic polymer, fluorinated organic polymer, or any other suitable high or low-k insulating layer.

The polishing method of the invention is particularly suited for use in conjunction with a chemical mechanical polishing (CMP) apparatus. Typically, the apparatus includes a platen, which, when in use, is in motion and has a velocity that results from orbital, linear, or circular motion, a polishing pad in contact with the platen and moving with the platen when in motion, and a carrier that holds a substrate to be polished by contacting and moving relative to the surface of the polishing pad. The polishing of the substrate takes place by the substrate being placed in contact with the polishing pad and the polishing composition of the invention and then the polishing pad moving relative to the substrate, so as to abrade at least a portion of the substrate (such as cobalt and a dielectric material as described herein) to polish the substrate.

In certain embodiments, optimal planarization may be achieved when the polishing rates of cobalt and the dielectric material are similar. For example, in certain embodiments the selectivity of cobalt to dielectric material may be in a range from about 1:10 to about 10 to 1. In certain embodiments, the polishing rate of the dielectric material may be greater than the polishing rate of cobalt such that the selectivity of cobalt to dielectric material may be less than 1:1 (e.g., in a range from 1:10 to about 1:1).

A substrate can be planarized or polished with the chemical mechanical polishing composition with any suitable polishing pad (e.g., polishing surface). Suitable polishing pads include, for example, woven and non-woven polishing pads. Moreover, suitable polishing pads can comprise any suitable polymer of varying density, hardness, thickness, compressibility, ability to rebound upon compression, and compression modulus. Suitable polymers include, for example, polyvinylchloride, polyvinylfluoride, nylon, fluorocarbon, polycarbonate, polyester, polyacrylate, polyether, polyethylene, polyamide, polyurethane, polystyrene, polypropylene, coformed products thereof, and mixtures thereof.

The following examples further illustrate the invention but, of course, should not be construed as in any way limiting its scope.

### EXAMPLE 1

Various polishing compositions were prepared (Control A and Example compositions 1-12). The example polishing compositions 1-12 included various azole compounds. Each of the thirteen polishing compositions was prepared by adding an appropriate amount of cationic colloidal silica particles having an average particle size of 50 nm to a corresponding mixture such that the cationic colloidal silica had a final concentration of 0.5 weight percent. The cationic colloidal silica particles were prepared as described in Example 7 of U.S. Patent 9,382,450. Each of the final compositions further included 1.68 mM of the corresponding azole compound, 2 mM Tris(hydroxymethyl)aminomethane, 125 ppm of a Kordek biocide, at a pH of 7.1. Control A did not include an azole compound. The particular azole compound used in each of Examples 1-12 is provided in Table 1. Each of the compositions (control A and Examples 1-12) had a zeta potential of about 25 mV at pH 7.1.

The cobalt etch rate of each of the above-described polishing compositions was evaluated. This example demonstrates the effect of certain azole compounds, particularly triazole compounds, as cobalt etch inhibitors. To obtain the cobalt etch rate for each polishing composition, the polishing composition was first heated to 45 degrees C after which a two-square centimeter wafer having a cobalt layer was immersed in the polishing composition (cobalt side up) for 5 minutes. Cobalt removal rates were determined via resistivity measurements made before and after immersion in the polishing compositions.

The cobalt etch rates are shown in Table 1. As stated above, Control A did not include an azole compound. The particular azole compounds used in each of the Example compositions 1-12 are indicated in the Table.

**Table 1**

| Polishing Composition | Azole Compound | Co Etch Rate, Å/min |
|---|---|---|
| Control A | NA | 10 |
| 1 | Benzotriazole (BTA) | 0.5 |
| 2 | 1H-1,2,3-Triazolo[4,5-b] pyridine | 0.3 |
| 3 | 1,2,4-Triazolo[1,5-a] pyrimidine | 3 |
| 4 | 1-Acetyl-1H-1,2,3-triazolo[4,5-b] pyridine | 0.5 |
| 5 | 1H-Benzotriazole-1-methanol | 1 |
| 6 | 5-Methyl-1H-benzotriazole | 1 |
| 7 | 2-(1,2,4-Triazol-3-yl) pyridine | 3 |
| 8 | 3H-[1,2,3]Triazolo[4,5-c] pyridine | 4 |
| 9 | 1H-Pyrazolo[3,4-b] pyridine | 8 |
| 10 | 7-Azaindole | 9 |
| 11 | Methyl 1H-benzotriazole-1-carboxylate | 12 |
| 12 | 7-Hydroxy-5-methyl[1,2,4] triazolo [1,5-a]pyrimidine | 12 |

As is apparent from the results set forth in Table 1, Example compositions 1-8, exhibited cobalt etch rates of 4 Å/min or less, which is less than one-half that of Control A (no inhibitor). Compositions 9-12 exhibited cobalt etch rates of 8 Å/min or more, which is similar to that of Control A.

### EXAMPLE 2

Cobalt and TEOS polishing rates as well as cleanability (defectivity) were evaluated in this example for polishing compositions 1-7 from Example 1. This example demonstrates that the use of triazole pyridine cobalt inhibitors results in the lowest number of defects after the post-CMP cleaning step. The cobalt and TEOS polishing rates were obtained by polishing blanket cobalt and TEOS wafers. The wafers were polished using a Mirra^{®} CMP polishing tool and a Fujibo H7000 polishing pad at a downforce of 1.5 psi, a platen speed of 93 rpm, and a head speed of 87 rpm. The slurry flow rate was 200 ml/min. After polishing, the cobalt wafers were cleaned using K8160-1 (available from Cabot Microelectronics) in an ONTRAK cleaner for 60 seconds in each of 2 brush boxes. Defect counts were collected using a Surfscan SP1 at a threshold of 0.16 µm. Defect images were collected using a scanning electron microscope and defect classification was completed through visual examination of the obtained images. The observed defects were predominately organic surface residue. The cobalt and TEOS polishing rates and the defect data are shown in Table 2.

**Table 2**

| Polishing Composition | Co Rate Å/min | TEOS Rate Å/min | Defects Counts |
|---|---|---|---|
| 1 | 140 | 675 | > 40,000 |
| 2 | 101 | 722 | 309 |
| 3 | 361 | 599 | > 40,000 |
| 4 | 73 | 606 | 688 |
| 5 | 157 | 679 | > 40,000 |
| 6 | 149 | 651 | > 40,000 |
| 7 | 459 | 632 | > 40,000 |

As is apparent from the results set forth in Table 2, the use triazole pyridine inhibitors resulted in the fewest number of defects indicating that these compounds are more easily removed from the cobalt substrate in the post-CMP cleaning step. The use of benzotriazole and benzotriazole compounds as a cobalt inhibitor resulted in a very large number of organic defects on the surface of the cobalt. The number of defects could not be reduced even with multiple post-CMP cleaning steps.

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

## Claims

1. A chemical mechanical polishing composition for polishing a cobalt containing substrate, the polishing composition comprising:
a water based liquid carrier;
cationic silica abrasive particles dispersed in the liquid carrier, the cationic silica abrasive particles having a zeta potential of at least 10 mV in the polishing composition;
a triazole compound, wherein the triazole compound is not benzotriazole or a benzotriazole compound; and
wherein the polishing composition has a pH from 6.5 to 9, and
wherein the cationic silica abrasive particles comprise colloidal silica particles having a permanent positive charge of at least 20 mV at a pH of greater than about 6.

2. The composition of claim 1, wherein the triazole compound is a triazole pyridine compound.

3. The composition of claim 2, wherein the triazole pyridine compound is 1H-1,2,3-Triazolo[4,5,b] pyridine, 1-Acetyl-1H-1,2,3-triazolo[4,5,b] pyridine, 3H-[1,2,3]Triazolo[4,5-c] pyridine, 2-(1,2,4-Triazol-3-yl) pyridine, or a mixture thereof.

4. The composition of claim 2, wherein the triazole pyridine compound is 1H-1,2,3-Triazolo[4,5,b] pyridine.

5. The composition of claim 2, comprising from about 50 to about 500 ppm of the triazole pyridine compound.

6. The composition of claim 1, wherein the polishing composition is substantially free of a per-compound oxidizer.

7. The composition of claim 1, having a pH from 6.5 to 8.

8. The composition of claim 1, wherein the cationic silica abrasive particles have an isoelectric point greater than about 9.

9. The composition of claim 1, comprising less than about 2 weight percent of the cationic silica abrasive particles.

10. A method of chemical mechanical polishing a substrate including a cobalt layer, the method comprising:
(a) contacting the substrate with a polishing composition of any one of claims 1 to 9;
(b) moving the polishing composition relative to the substrate; and
(c) abrading the substrate to remove a portion of the cobalt layer from the substrate and thereby polish the substrate.

11. The method of claim 10, wherein the substrate further comprises a dielectric layer and wherein the abrading in (c) also removes a portion of the dielectric layer from the substrate.

12. The method of claim 10, wherein a removal rate of the dielectric layer in (c) is greater than a removal rate of cobalt in (c).

13. The method of claim 12, wherein the dielectric layer is tetraethyl orthosilicate (TEOS).

14. A chemical mechanical polishing composition for polishing a cobalt containing substrate, the polishing composition comprising:
a water based liquid carrier;
cationic silica abrasive particles dispersed in the liquid carrier, the cationic silica abrasive particles having a zeta potential of at least 10 mV in the polishing composition;
a triazole pyridine compound; and
wherein the polishing composition has a pH from 6.5 to 9.

## Patentansprüche

1. Chemisch-mechanische Polierzusammensetzung zum Polieren eines kobalthaltigen Substrats, wobei die Polierzusammensetzung umfasst:
einen wasserbasierten flüssigen Träger;
kationische Siliziumdioxid-Schleifpartikel, die in dem flüssigen Träger dispergiert sind, wobei die kationischen Siliziumdioxid-Schleifpartikel ein Zetapotenzial von mindestens 10 mV in der Polierzusammensetzung aufweisen;
eine Triazolverbindung, wobei die Triazolverbindung nicht Benzotriazol oder eine Benzotriazolverbindung ist; und
wobei die Polierzusammensetzung einen pH-Wert von 6,5 bis 9 aufweist, und
wobei die kationischen Siliziumdioxid-Schleifpartikel kolloidale Siliziumdioxidpartikel umfassen, die eine permanente positive Ladung von mindestens 20 mV bei einem pH-Wert von größer als etwa 6 aufweisen.

2. Zusammensetzung nach Anspruch 1, wobei die Triazolverbindung eine Triazolpyridinverbindung ist.

3. Zusammensetzung nach Anspruch 2, wobei die Triazolpyridinverbindung 1H-1,2,3-Triazolo[4,5,b]pyridin, 1-Acetyl-1H-1,2,3-triazolo[4,5,b]pyridin, 3H-[1,2,3]Triazolo[4,5-c]pyridin, 2-(1,2,4-Triazol-3-yl)pyridin oder eine Mischung davon ist.

4. Zusammensetzung nach Anspruch 2, wobei die Triazolpyridinverbindung 1H-1,2,3-Triazolo[4,5,b]pyridin ist.

5. Zusammensetzung nach Anspruch 2, umfassend von etwa 50 bis etwa 500 ppm der Triazolpyridinverbindung.

6. Zusammensetzung nach Anspruch 1, wobei die Polierzusammensetzung im Wesentlichen frei von einem Perverbindungs-Oxidationsmittel ist.

7. Zusammensetzung nach Anspruch 1, die einen pH-Wert von 6,5 bis 8 aufweist.

8. Zusammensetzung nach Anspruch 1, wobei die kationischen Siliziumdioxid-Schleifpartikel einen isoelektrischen Punkt von größer als etwa 9 aufweisen.

9. Zusammensetzung nach Anspruch 1, umfassend weniger als etwa 2 Gewichtsprozent der kationischen Siliziumdioxid-Schleifpartikel.

10. Verfahren zum chemisch-mechanischen Polieren eines Substrats, das eine Kobaltschicht einschließt, wobei das Verfahren umfasst:
(a) Inkontaktbringen des Substrats mit einer Polierzusammensetzung nach einem der Ansprüche 1 bis 9;
(b) Bewegen der Polierzusammensetzung relativ zu dem Substrat; und
(c) Abschleifen des Substrats, um einen Teil der Kobaltschicht von dem Substrat zu entfernen und dadurch das Substrat zu polieren.

11. Verfahren nach Anspruch 10, wobei das Substrat ferner eine dielektrische Schicht umfasst und wobei das Abschleifen in (c) auch einen Teil der dielektrischen Schicht von dem Substrat entfernt.

12. Verfahren nach Anspruch 10, wobei eine Entfernungsrate der dielektrischen Schicht in (c) größer ist als eine Entfernungsrate von Kobalt in (c).

13. Verfahren nach Anspruch 12, wobei die dielektrische Schicht aus Tetraethylorthosilikat (TEOS) besteht.

14. Chemisch-mechanische Polierzusammensetzung zum Polieren eines kobalthaltigen Substrats, wobei die Polierzusammensetzung umfasst:
einen wasserbasierten flüssigen Träger;
kationische Siliziumdioxid-Schleifpartikel, die in dem flüssigen Träger dispergiert sind, wobei die kationischen Siliziumdioxid-Schleifpartikel ein Zetapotenzial von mindestens 10 mV in der Polierzusammensetzung aufweisen;
eine Triazolpyridinverbindung; und
wobei die Polierzusammensetzung einen pH-Wert von 6,5 bis 9 aufweist.

## Revendications

1. Composition de polissage mécano-chimique destinée au polissage d'un substrat contenant du cobalt, la composition de polissage comprenant :
un porteur liquide à base d'eau ;
des particules abrasives de silice cationique dispersées dans le porteur liquide, les particules abrasives de silice cationique ayant un potentiel zêta d'au moins 10 mV dans la composition de polissage ;
un composé triazole, dans laquelle le composé triazole n'est ni du benzotriazole ni un composé benzotriazole ; et
dans laquelle la composition de polissage a un pH de 6,5 à 9, et
dans laquelle les particules abrasives de silice cationique comprennent des particules de silice colloïdale ayant une charge positive permanente d'au moins 20 mV à un pH supérieur à environ 6.

2. Composition selon la revendication 1, dans laquelle le composé triazole est un composé triazole-pyridine.

3. Composition selon la revendication 2, dans laquelle le composé triazole-pyridine est 1H- 1,2,3-Triazolo[4,5,b] pyridine, 1-Acétyl-1H-1,2,3-triazolo[4,5,b] pyridine, 3H- [1,2,3]Triazolo[4,5-c] pyridine, 2-(1,2,4-Triazol-3-yl) pyridine, ou un mélange de ceux-ci.

4. Composition selon la revendication 2, dans laquelle le composé triazole-pyridine est 1H- 1,2,3-Triazolo[4,5,b] pyridine.

5. Composition selon la revendication 2, comprenant d'environ 50 à environ 500 ppm du composé triazole-pyridine.

6. Composition selon la revendication 1, dans laquelle la composition de polissage est sensiblement exempte de composé peroxydant.

7. Composition selon la revendication 1, ayant un pH de 6,5 à 8.

8. Composition selon la revendication 1, dans laquelle les particules abrasives de silice cationique ont un point isoélectrique supérieur à environ 9.

9. Composition selon la revendication 1, comprenant moins d'environ 2 % en poids de particules abrasives de silice cationique.

10. Procédé de polissage mécano-chimique d'un substrat comportant une couche de cobalt, le procédé comprenant :
(a) la mise en contact du substrat avec une composition de polissage selon l'une quelconque des revendications 1 à 9 ;
(b) le déplacement de la composition de polissage par rapport au substrat ; et
(c) l'abrasion du substrat pour éliminer une partie de la couche de cobalt du substrat et polir ainsi le substrat.

11. Procédé selon la revendication 10, dans lequel le substrat comprend en outre une couche diélectrique et dans lequel l'abrasion en (c) élimine également une partie de la couche diélectrique du substrat.

12. Procédé selon la revendication 10, dans lequel un taux d'élimination de la couche diélectrique en (c) est supérieur au taux d'élimination du cobalt en (c).

13. Procédé selon la revendication 12, dans lequel la couche diélectrique est de l'orthosilicate de tétraéthyle (TEOS).

14. Composition de polissage mécano-chimique destinée au polissage d'un substrat contenant du cobalt, la composition de polissage comprenant :
un porteur liquide à base d'eau ;
des particules abrasives de silice cationique dispersées dans le porteur liquide, les particules abrasives de silice cationique ayant un potentiel zêta d'au moins 10 mV dans la composition de polissage ;
un composé triazole-pyridine ; et
dans lequel la composition de polissage a un pH de 6,5 à 9.
